# EUROPEAN PATENT APPLICATION

(11) **EP 4 276 479 A1**
(43) Date of publication of application: **15.11.2023**
(21) Application number: 23173038.3
(22) Date of filing: 12.05.2023
(51) Int. Cl.: G01R 29/08, G01R 29/10

(54) **TEST ARRANGEMENT AND TEST SYSTEM**

(30) Priority: 13.05.2022 FI 20225422
(71) Applicant: JOT Automation Oy, 90590 Oulu (FI)
(72) Inventor: Harju, Esa, 90590 Oulu (FI)
(74) Representative: Kolster Oy Ab

(57) **Abstract**

A test arrangement (100) comprising a demountable platform (102), at least one test chamber (104) arranged in the demountable platform (102) wherein the test chamber (104) is configured to receive test equipment (106) and a product to be tested, and transport equipment (108) arranged in the test arrangement (100) for moving the product to be tested, and a frame structure (114) configured to cover, at least partly, the test arrangement (100) such that at least the test chamber (104) is substantially inside the frame structure (114).

## Description

### Field

The invention relates to a field of test arrangements, especially modular test arrangements.

### Background

Testing of products is an essential part of manufacturing activities. Needs for the testing capacity often vary over the time. Testing arrangements are often complicated and need a lot of space. This is the case especially with large test chambers used in RF - testing, for example. Therefore, adjusting of the testing capacity to meet the actual needs may be challenging. A wide variety of solutions are available in the market to solve the issue. Still, the known solutions have some drawbacks. The drawbacks relate especially to scalability of the testing arrangement and usability of the testing arrangement. Hence, there is a need for a more sophisticated testing arrangement.

### Brief description

The invention is defined by the independent claims. Embodiments are defined in the dependent claims.

The embodiments and features, if any, described in this specification that do not fall under the scope of the independent claim are to be interpreted as examples useful for understanding various embodiments of the invention.

### List of drawings

Example embodiments of the present invention are described below, by way of example only, with reference to the accompanying drawings, in which
Figures 1A and 1B illustrate a test arrangement according to an embodiment of the invention; and
Figures 2A, 2B, 3, 4A, 4B and 4C illustrate a test system according to an embodiment of the invention.

### Description of embodiments

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned. All combinations of the embodiments are considered possible if their combination does not lead to structural or logical contradiction.

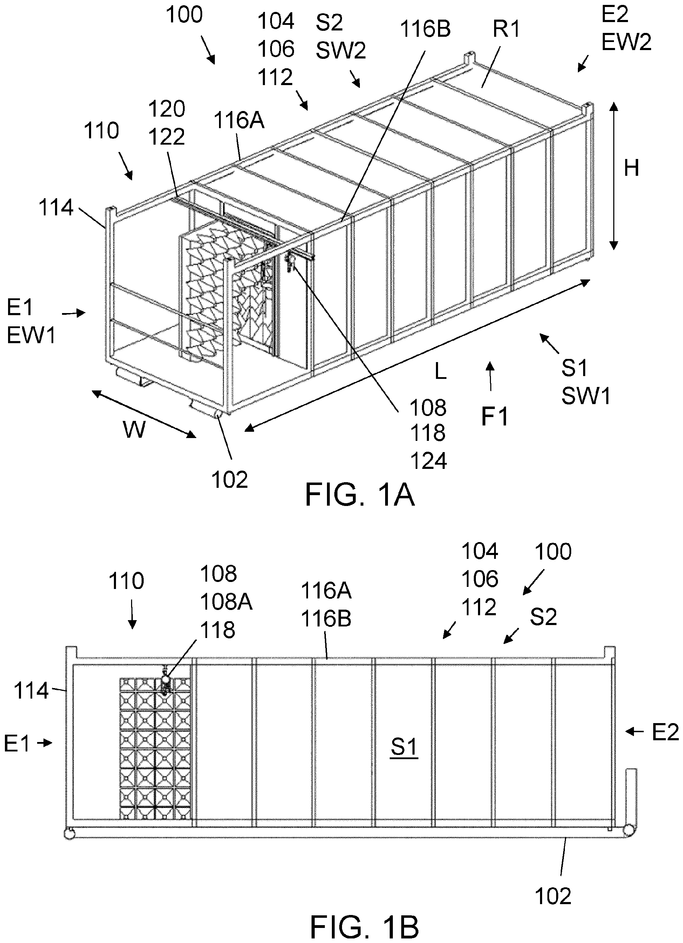

Referring to Figure 1A and 1B, according to an aspect, there is provided a test arrangement 100 comprising a demountable platform 102, at least one test chamber 104 arranged in the demountable platform 102 wherein the test chamber 104 is configured to receive test equipment 106 and a product to be tested, transport equipment 108 arranged in the test arrangement 100 for moving the product to be tested, and a frame structure 114 configured to cover, at least partly, the test arrangement 100 such that at least the test chamber 104 is substantially inside the frame structure 114.

The demountable platform (also platform later in this application) refers to a standard platform used especially with trucks. The demountable platform comprises a standard coupling/lifting interface configured to be coupled with the truck. The demountable platform as such, in this context, may not comprise any cargo space, it is so called flat bed. The demountable platform is a base on which the cargo space, open or closed, may be assembled. Instead of the cargo space, the test chamber is built and assembled on the demountable platform in the invention. A size of the demountable platform can be scaled according to the needs, especially in a length direction (longitudinal direction). The demountable platform provides very effective base for building the modular test arrangement. It is easy and effortless to move by the truck, for example. The standard demountable platform and its structure is widely known and therefore is not presented in detail in this application. It is good to realize that the demountable platform is very different than the standard freight container which may be used with the test arrangements.

The test arrangement comprises at least one test chamber arranged on the platform. The test chamber may be arranged on the top of the platform. In other words, on a side of the platform which is facing up in normal use. The test chamber is, at least partly, a closed room with the test equipment. The test chamber comprises walls, a floor, and a roof. The test equipment and the product(s) to be tested may be placed, at least partly, inside the room. The test chamber may comprise one or more doors enabling access to inside the room. The door may be manual or automated. The automated door can be opened and/or closed automatically without physical contact of the operator. The manual door may be opened and/or closed manually by the operator.

The term "test chamber" shall be understood broadly. It may comprise a space for testing the devices, and further also a space for controlling the test, for example. So, the test chamber may not be just a single room for testing the devices. A size of the test chamber may be adjusted according to the needs. The size of the test chamber and/or the whole test arrangement may be adjusted such that it can be placed on the platform, and the platform can still be transported by the truck, for example. Hence, the size of the platform may affect/limit the dimensions of the test chamber and/or the test arrangement. The test chamber may be dimensioned such that operator(s) may be able to work inside the chamber. The test chamber may be made of a sheet metal. The test chamber may also comprise a ventilation arrangement.

In an embodiment, test chamber may be used for RF - testing of electronic devices against standards. Hence, the test chamber may be a RF - test chamber comprising RF - test equipment. The inner side of the test chamber may comprise anechoic material(s). The test equipment mention in this application may be aimed for RF-testing and the product to be tested may be the electronic device. The test equipment may also comprise a jig and/or a fixture for the product to be tested. The RF - test chamber and its functions as such are widely known in the prior art and therefore is not presented in detail in this application. The invention provides a modular structure to which the RF - testing equipment may be assembled for testing the electronic products. It is also important to realize that the test arrangement may be used also for other test purposes than the RF - testing. The RF - testing is just one example.

Control and input/output systems and their interfaces, and application programming interfaces and their structures of the test equipment and/or the product(s) to be tested are widely known and therefore are not presented in detail in this application.

In an embodiment, the arrangement further comprises the transfer equipment, arranged in the test arrangement, for moving the objects. The object may refer to the product(s) to be tested and or the test equipment used in testing, for example. The transfer equipment is a device which helps moving of the objects. In other words, the operator does not need to lift/move manually the objects that may be heavy. This significantly improves the usability of the test arrangement. The transfer equipment may be configured to move the product outside and/or inside the test chamber. For example, the transfer equipment may be used to move the product to be tested from the outside to inside of the test chamber, or vice versa.

In an embodiment, the test arrangement comprises a supporting frame 114. The supporting frame, or the frame structure, may substantially cover, at least partly, the test arrangement as illustrated in Figure 1, for example. In an embodiment, it extends substantially from the floor level to the roof level, and from a first end E1 to a second end E2 of the platform. The roof and/or floor level may refer to the roof and floor of the chamber.

In an embodiment, the supporting frame covers the test arrangement such that at least the test chamber is substantially inside the frame. As the test arrangement may be assembled on the open platform (demountable platform), the frame structure may be used as a load-bearing structure. In other words, it creates the strength and stiffness of the test arrangement. For example, the walls and roof of the test chamber may be coupled with the frame. The frame structure enables also to stack the test arrangements on top of each other. For example, if a plurality of the test arrangements is coupled together, each the arrangement may comprise the frame structure and test arrangements may be coupled together from the frame structures. Conventionally the transportable test arrangements are built within the standard freight containers, and the separate frame structure is not needed. The supporting frame may comprise at least longitudinal side beams 116A, 116B extending in the roof level from the first end of the test arrangement E1 to the second end of the test arrangement E1 in the vicinity of the sides of the arrangement S1, S2. The supporting frame may further comprise, at least in every side corner of the arrangement, vertical beams extending from the floor level to the roof level and coupled with the side beams. The frame may further comprise horizontal beams between the side beams and/or the side beams.

The test arrangement on the demountable platform provides the solution that is easy to build according to the needs. It is also easy to move. The standard coupling/lifting mechanism of the demountable platform and/or the truck make possible to easily couple the test arrangement with the truck. The test arrangement may be placed indoor and/or outdoor. It may be placed inside the production facilities, or it may be placed outside the production facilities. The test arrangement according to the invention provides an alternative solution for the know test arrangements that are placed inside a standard container. In addition, the transfer equipment makes possible to move the products to be tested as well as the test equipment effortlessly which improves the usability of the test arrangement.

Referring to Figure 1A, in an embodiment, the test arrangement 100 comprises an outer space 110. The outer space may comprise a common floor with an inner space. The inner space may be the test chamber 104 in which the test equipment 106 may be placed. The outer space may not have the walls and/or the roof. The outer space may extend on the floor level from the inner space in a longitudinal direction of the test arrangement L. A width of the outer space W may be the same as a width of the inner space. The door may be placed in the wall between the outer and inner space such that the operator may enter from the outer space into the inner space and vice versa. In an embodiment, the supporting frame is configured to cover the outer space of the test arrangement. In other words, the inner space is arranged inside the frame structure. Then both the inner and outer space may be substantially inside the frame structure, in other words, are cover by the frame structure. A ration between the inner and outer space may be adjusted according to the needs on the platform (test arrangement).

Referring to Figure 1A, in an embodiment, the transport equipment 108 is arranged in the supporting frame 114 in the outer space of the test arrangement 110. The transport equipment may be coupled with the side beams of the supporting frame. Hence, the transport equipment may be placed in the vicinity of the roof level. The transport equipment may be coupled with a power source like an electric motor configured to provide force for transfer.

Still referring to Figure 1A, in an embodiment, the transport equipment 108 comprises a hoist 118. The hoist may comprise a hoist device with a wire rope 124 and one or more rails 120, 122 enabling the movement of the hoist device 118 in a direction of the rails 120, 122. A first rail 120 may be arranged in the side beams of the supporting frame 116A, 116B such that the first rail 120 is substantially perpendicular in relation to the side beams 116A, 116B. The first rail enables movement of the hoist in the width direction W of the test arrangement. The hoist may further comprise one or more second rails 122 coupled with the first rail 120 enabling the movement of the first rail 120 in the direction of the one or more second rails 122. The second rails may be coupled with the side beams of the supporting frame 116A, 116B, and extend parallel with the beams. This enables movement of the hoist in the longitudinal direction L of the test arrangement. The rail(s) of the hoist may extend inside the test chamber as well making possible to move the object inside the test chamber.

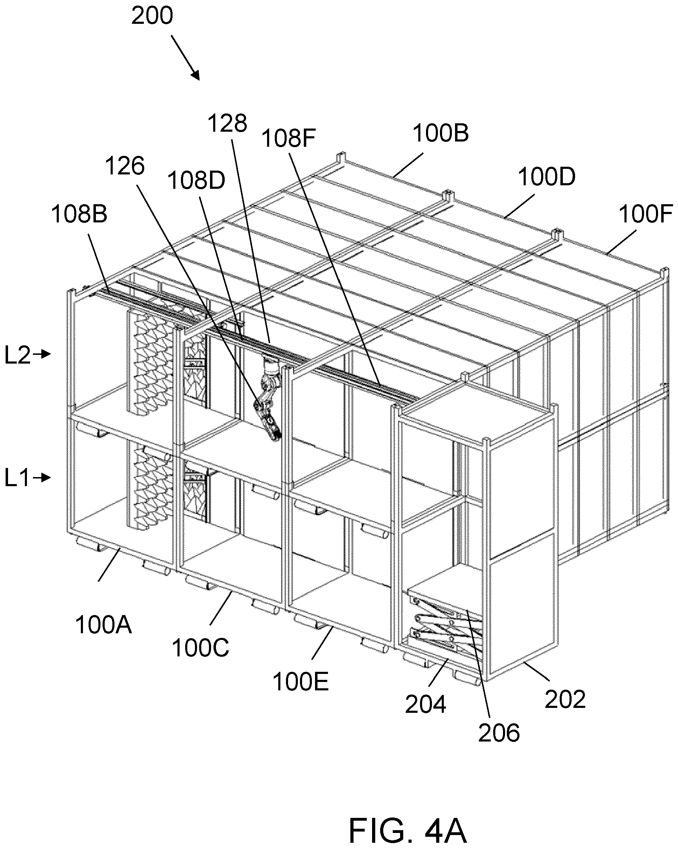

In an embodiment, the transport equipment comprises a robot arm. Referring now to Figure 4A, which illustrates a test system having a plurality of the test arrangements coupled together. The robot arm 126 may be coupled with the side beams of the frame supports 116A, 116B. The robot arm may comprise a rail 128 coupled with the side beams of the frame supports 116A, 116B such that the rail 128 is substantially perpendicular in relation to the beams. The rail enables the movement of the robot arm in the width direction W of the test arrangement. The robot arm may also be configured to move in the longitudinal direction L of the arrangement. In one embodiment, an operation range of the robot arm can cover the whole outer space of the test arrangement. In another embodiment, an operation range of the robot arm can cover the whole outer space of the test arrangement, and further at least partly, the inner space of the test arrangement. Hence, the robot arm can move the object in the outer space and/or at least partly in the inner space of the test arrangement. The rail(s) of the robot arm may extend inside the test chamber as well. This makes possible to move the object inside the test chamber by the robot arm. Still referring to Figure 4A, the test fixture in which the product is tested may be placed in the vicinity of the door. Then the robot arm may be capable of placing the product in the fixture. In other words, the fixture may be in the operating range of the robot arm. The arrangement may further comprise means for protecting the operating range of the robot arm. The protecting means prevent persons to enter the operating range when the robot is in use.

In an embodiment, the test arrangement comprises two separate test chambers. This is not illustrated in Figures. Both test chambers may comprise at least one door allowing access to the chambers. The test chamber, illustrated in Figure 1A, may be divided into two separated test chambers in the longitudinal direction L by a wall. A first test chamber may comprise at least one door in the first end E1 and/or the side S1 and/or the side S2 of the test arrangement, and a second test chamber may comprise at least one door in the second end E2 and/or the side S1 and/or the side S2 of the test arrangement.

In an embodiment, the test chamber comprises a roof, a floor, a first and a second end wall and a first and a second side wall, wherein the roof, the floor and/or at least one wall is detachable. Referring to Figure 1A, the test chamber 104 comprises the floor F1, the roof R1, the first and the second side walls SW1, SW2 and the first and the second end walls EW1, EW2 forming the internal space of the test arrangement 112. As described above, the floor F1 may be common with the outer space 110. The roof, the floor and/or at least one of the walls may be detachable. The detachable refers to the structure which is build such that it can be dismantled (removed). Dismantling of the structure enables to couple a plurality of the test arrangements together such that the inner spaces of the test arrangements may be connected to form uniform test chamber. In other words, detachable structure enables the modularity and the scalability of the test arrangement.

According to another aspect of the invention, there is provided the test system comprising a plurality of the test arrangements coupled together. The test arrangement may comprise one or more features described in this application. By coupling together one or more test arrangements, the testing capacity can be easily adjusted to meet the real testing needs. The system formed of together coupled arrangements may form separate test chambers such that each of the test chambers of the test arrangement are a separate testing room, or two or more test chambers may be coupled together to form a bigger uniform test roof. For example, if the system comprises two test arrangements, the arrangements may form two separate test chambers, or the test chambers may be coupled such that chambers form one uniform test chamber (room). As described above, the structure of the test chamber may be detachable allowing easily to remove the wall(s), the roof and/or the floor between the chambers to from the uniform test room.

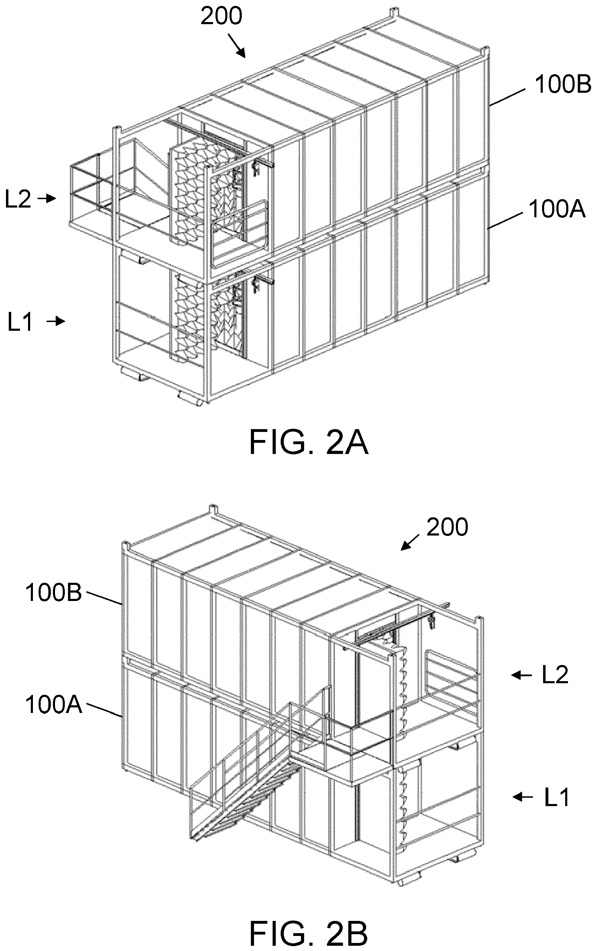

In an embodiment, the test system comprises at least two test arrangements that are arranged on top of each other. Referring to Figure 2A and 2B, which illustrates the test system 200 comprising a first and a second test arrangement 100A, 100B, and wherein the second arrangement 100B is on the top of the first arrangement 100A. The first arrangement 100A from a first layer (floor) L2 and the second arrangement 100B forms a second layer (floor) L2. Figure 2A and 2B illustrate the test system according to an embodiment in which the test chambers of the test arrangements 100A, 100B are the separate test rooms. In other words, there is two separate test chambers and hence, the test chambers are not integrated together to form one uniform test room. Anyway, as described above, the test chamber of the arrangement may also be integrated, and then the roof of the lower test chamber and the floor of the upper test chamber is, at least partly, removed. Both test arrangements may comprise at least one door allowing access to the test chambers. The test system may further comprise stairs with handrails enabling access to the second arrangement 100B. The stairs and/or handrails may be coupled with the outer space of the arrangement. Nevertheless, Figures 2A and 2B illustrate the test system having two layers (floors) but it is possible that there is more than two layers in the test system.

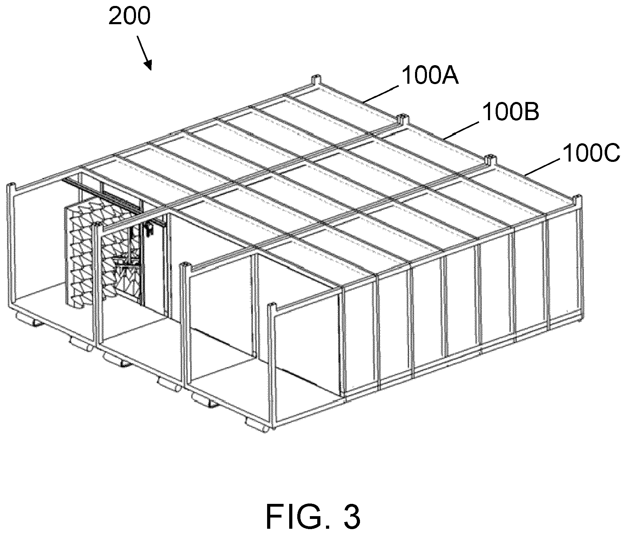

In an embodiment, the test system comprises at least two test arrangements that are arranged side by side. Referring to Figure 3, the test system 200 may comprise at least two test arrangements 100A, 100B, 100C placed side by side and coupled together. Figure 3 illustrates an embodiment in which three arrangements 100A, 100B, 100C are arranged side by side. The arrangements may be placed side by side such that the first and/or the second side S1, S2 of a first test arrangement is coupled with the first and/or the second side S1, S2 of a second test arrangement. The test chambers of the arrangements are integrated together such that the test chambers form one uniform test room. Since the test chambers are integrated together, only the one arrangement may comprises the door. The outer spaces of the test arrangement may also form one uniform space as illustrated in Figure 3. The outer spaces of the test arrangement may also form one uniform space even though the test chambers are not integrated together. The test arrangements may also be placed side by side such that the second ends E2 of two test arrangements are coupled together, for example.

In an embodiment, the test system comprises a plurality of the test arrangements arranged on the top of each other and side by side. Referring to Figure 4A, the test system 200 may comprise at least two test arrangements 100A, 100B on the top of each other, and further at least two test arrangements 100A, 100C side by side. In an embodiment of Figure 4A the test system comprises totally six test arrangements such that there are two arrangements in a vertical direction (height direction H) forming two layers L1, L2 and three test arrangements in a horizontal direction (width direction W). The above-mentioned test system forms an upper test room (test arrangements 100B, 100D, 100F) and a lower test room (test arrangements 100A, 100C, 100E). The test arrangements 100B, 100D, 100F forms one uniform test room in the second level L2, and the test arrangements 100A, 100C, 100E form one uniform test room in the first level L1. This is just one example how the test system may be formed from the test arrangements, the amount and placing of the test arrangements in the test system may vary according to the needs.

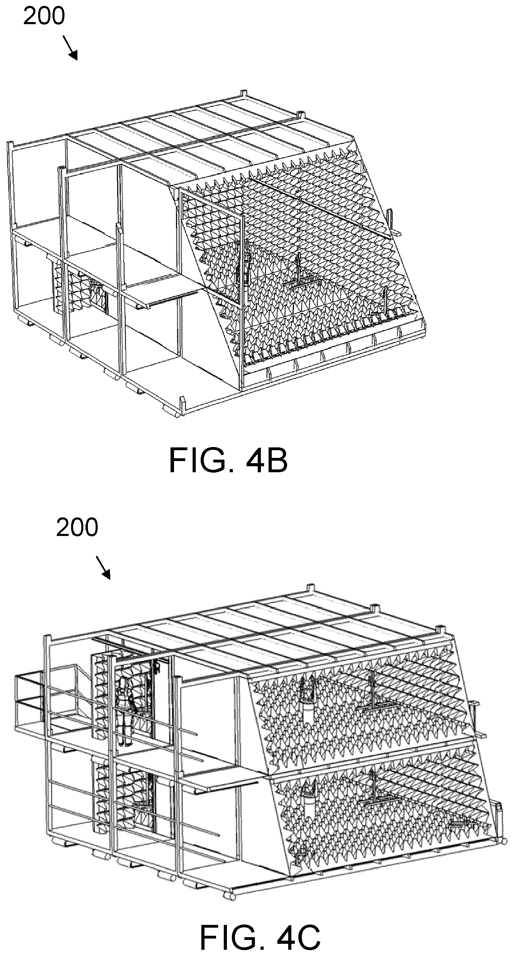

As illustrated above, the test system comprises at least two test arrangements. The test arrangements may be placed side by side and/or on the top of each other. In one embodiment of the test system, at least some of the test chambers of the test arrangements (inner spaces) may be, at least partly, integrated together such that they form the uniform test room. In another embodiment of the test system, the test chambers of the test arrangements (inner spaces) may not be integrated together. In this embodiment, each test chamber of the test arrangement may be the separate test room. In addition to the inner space, at least some of the outer spaces of the test arrangement forming the test system may be integrated together such that the outer spaces form, at least party, the uniform outer space as illustrated in Figure 4, for example.

Figures 4B and 4C illustrate the test system according to the above-mentioned embodiments. Figure 4B is a section view of the test system in which all the test arrangements (totally six in two levels) form one uniform test room. Figure 4C is a section view of the test system (illustrated also in Figure 4A) having two levels and two separate test rooms (lower and upper).

In an embodiment, illustrated in Figure 4A, the test system 200 further comprises an elevator module 202. The elevator module is configured to move vertically the object like the products to tested and/or the test equipment. The elevator may be an own module arranged in the demountable platform like the test arrangement. Hence, the elevator module is using the same base as the test arrangements. An operation range of the elevator module may be adjusted according to the height of the test system. If the test system has a height of two test arrangements, in other words it has the first and the second floor, the elevator module is dimensioned such that it can transfer the object between the floors as illustrated in Figure 4A, for example.

The elevator may be arranged in the test system such that it is in the vicinity of the outer space of the test arrangement. The elevator may be arranged in one side of the outer space as illustrated in Figure 4A, for example. A length of the elevator module (direction L) may be substantially the same as the length of the outer space. The elevator module may comprise a framework around it. The framework may be coupled with the frame structure of the test arrangement when the elevator is coupled to the test system.

The elevator module is configured to lift the objects from the outer space of the test arrangement(s) of the first floor to the outer space of the test arrangement of the second floor. Still, it is important to realize that there may be more floors (levels) than two in the test system, and the elevator module can transfer the object(s) between them. The elevator comprises a floor plate 204 configured to receive the object to be lifted. The floor plate is coupled with a lift mechanism 206. The lift mechanism may be a hydraulic scissor lift, for example. The lifting mechanism is coupled with a power source like an electric motor configured to provide lifting force.

In an embodiment, the elevator is arranged in an operating range of the transfer equipment of the test arrangement. Still referring to Figure 4A, the test arrangement(s) in the test system 200 may comprise the transfer equipment 108 as illustrated above. The elevator 202 is arranged in the test system 200 such that it is, at least partly, in the operating range of the transfer equipment 108. Or at least in the vicinity of the operating range. Then the object like the product to be tested can be moved to/from the elevator by the transfer equipment. For example, the transfer equipment may comprise the robot arm having, at least, the rail enabling movement in the width direction W. The rail may extend into the elevator module as well. Then the robot arm may be driven inside the elevator module. The robot arm may then pick up the product from the elevator and transfer it inside the test chamber, or vice versa, for example.

In an embodiment, the transfer equipment of a plurality of the test arrangement are configured, at least partly, to be integrated together. Figure 4A illustrates the test system having three test arrangements side by side in two levels (floors). The transfer equipment 108B, 108D, 108F of the adjacent test arrangements 100B, 100D, 100F in the second level (floor) may be integrated together such that they form a uniform transfer equipment making possible to move the object in the second level L2. As described above, the outer spaces of the test arrangements may be integrated together, and this makes possible to integrate the transfer equipment together since the transfer equipment may be assembled in the outer space. Then the transfer equipment is configured to transfer the object in a whole width of the test system.

In addition, the transfer equipment of the adjacent test arrangements in the first level L1 (floor) may be integrated together such that they form the uniform transfer equipment nevertheless this is not illustrated in Figure 4A.

Still referring to Figure 4A, the first layer L1 may form a first uniform test room and the second layer L2 may form a second uniform test room, and both layers may comprise at least one door. The door may be placed on the opposite side of the test system (arrangements 100A, 100B) compared to the elevator (in vicinity of arrangements 100E, 100F). The transfer equipment can be used to transfer the object from the door to the elevator or vice versa.

If the test chambers of two or more test arrangements are coupled together and the test system is used for RF - testing, the structure in a coupling interface may comprise a RF - gasket for ensuring proper contact between the test chambers. The coupling interface refers to an interface between the two adjacent test chambers from which the wall(s), roof(s) and/or the floor(s) are removed to form the uniform test room.

The invention provides a solution in which the test arrangement is assembled on the (standard) demountable platform. Because of the demountable platform, the test arrangement is very easy to move for example by the truck having the suitable coupling interface for the demountable platform. The test arrangement is modular allowing to form the test system that meets the actual needs of the test capacity. Increasing or decreasing of the test capacity is easy due to the modularity of the test arrangement. The structure of each test arrangement makes possible to build larger test rooms by integrating the test chambers together. Referring to Figures 1A and 3, if there is a need for the test system having three test arrangements side by side such that the test chambers form one uniform test room, then three test arrangements are provided such that the first arrangement 100A has not the first side wall SW1, the second arrangement 100B has not the first and the second side walls SW1, SW2, and the third arrangement 100C has not the second side wall SW2. The arrangements are moved to the destination in which they are going to be used, and the arrangements are joined together to form the test system having one uniform test room. When the above-mentioned walls are missing, the test arrangements form the one uniform test room.

The test arrangement comprises the transfer equipment making possible to move the object like the product to tested. The transfer equipment of a plurality of the test arrangements may also be integrated together to form the uniform and common transfer equipment for the whole test system. The test system may have a plurality of layers (floors) and may further comprise the elevator module making possible to move the object vertically between the layers. The elevator module may be assembled on the demountable platform as well having the same benefits as the test arrangements. The test arrangement and/or the test system comprises a control unit. The control unit may be remote, or the test system and/or arrangement may comprise an integral control unit. The test arrangement and/or the test system may be automated such that changing of the product to be tested and testing itself may be performed automatically for example via remote control unit.

The test arrangement and/or the test system may also comprise an interface for an electrical network, a communication network, a sewerage system and/or a water supply system, for example.

It will be obvious to a person skilled in the art that, as technology advances, the inventive concept can be implemented in various ways. The invention and its embodiments are not limited to the example embodiments described above but may vary within the scope of the claims.

## Claims

1. A test arrangement (100), comprising:
a demountable platform (102);
at least one test chamber (104) arranged on the demountable platform (102) wherein the test chamber (104) is configured to receive test equipment (106) and a product to be tested;
transport equipment (108) arranged in the test arrangement (100) for moving the product to be tested; and
a frame structure (114) configured to cover, at least partly, the test arrangement (100) such that at least the test chamber (104) is substantially inside the frame structure (114).

2. The test arrangement (100) of claim 1, wherein the test arrangement (100) comprises an outer space (110).

3. The test arrangement (100) of claim 2, wherein the frame structure (114) is configured to cover substantially the outer space (110) of the test arrangement (100).

4. The test arrangement of any preceding claim, wherein the transport equipment (108) is arranged at least in the frame structure (114) of the outer space of the test arrangement (100).

5. The test arrangement (100) of any preceding claim, wherein the transport equipment (108) comprises a hoist (118) and/or a robot arm (126).

6. The test arrangement (100) of claim 5, wherein an operation range of the robot arm (126) is configured to cover an outer space and at least partly an inner space of the test arrangement (100).

7. The test arrangement (100) of any preceding claim, wherein the arrangement (100) comprises at least two separate test chambers (104).

8. A test system (200) comprising a plurality of a test arrangements (100) of claims 1 - 7 coupled together.

9. The test system (200) of claim 8, wherein the test system (200) comprises at least two test arrangements (100) placed on top of each other.

10. The test system (200) of claim 8, wherein the test system (200) comprises at least two test arrangements (100) placed side by side.

11. The test system (200) of claims 9 - 10, wherein the test system (200) comprises a plurality of the test arrangements (100) placed on top of each other and side by side.

12. The test system (200) of claims 8 - 11, wherein the test system (200) further comprises an elevator module (202) arranged in a demountable platform (102).

13. The test system (200) of claims 12, wherein the elevator is arranged in an operating range of transport equipment (108) of the test arrangement (100).

14. The test system (200) of claims 8 - 13, wherein at least part of a plurality of the test arrangements (100) are configured to form a uniform outer and/or inner space.

15. The test system (200) of claims 8 - 14, wherein the transport equipment (108) of a plurality of the test arrangement (100) are configured, at least partly, to be integrated together.
